# EUROPEAN PATENT APPLICATION

(11) **EP 2 858 221 A1**
(43) Date of publication of application: **08.04.2015**
(21) Application number: 13187504.9
(22) Date of filing: 07.10.2013
(51) Int. Cl.: H02M 1/32, H02M 7/5388, H03K 17/08, H03K 17/0812, H03K 17/0814

(54) **Short circuit protection**

(71) Applicant: ABB Oy, 00380 Helsinki (FI)
(72) Inventor: Park, Ki-Bum, 5405 Baden-Dättwil (CH); Pettersson, Sami, 5405 Baden-Dättwil (CH); Canales, Francisco, 5405 Baden-Dättwil (CH)
(74) Representative: Kolster Oy Ab

(57) **Abstract**

A circuit with short circuit protection comprising two or more series connections of normally-on switches, each series connection comprising a high-side and a low-side normally-on switch, wherein the source electrodes of the low-side normally-on switches (J_{L1}, J_{L2}, J_{L3}) being connected to a same potential, and gate drivers (GDJ) for controlling the normally-on switches. The circuit further comprises a diode (d_{c1}, d_{c2}, d_{c3}) for each of the low-side normally-on switch, the anodes of the diodes being connected to the gate electrodes of the respective low-side normally-on switches and the cathodes of the diodes are connected to a common point, and a controllable semi-conductor switch (M) connected between the potential of source electrodes of the low-side normally-on switches (J_{L1}, J_{L2}, J_{L3}) and the common point to which the cathodes of the diodes (d_{c1}, d_{c2}, d_{c3}) are connected.

## Description

### FIELD OF THE INVENTION

The present invention relates to short circuit protection of normally-on type switches, and particularly to short circuit protection circuits of normally-on type JFET components.

### BACKGROUND OF THE INVENTION

Wide band gap semiconductors are the most promising materials for power electronics. SiC power semiconductor devices are capable of high voltage, high frequency, and high temperature operation, which enable higher efficiency and higher power density designs. The normally-on type (N-on) JFET is the most mature device among the currently available SiC active switches. However, it has certain features which make its use more challenging compared to standard normally-off type devices. In normally-on type switches a negative gate voltage must be applied to turn off the switch and additional protection and/or startup circuits are required due to the normally-on characteristic.Startup and protection, in particular, are critical issues.

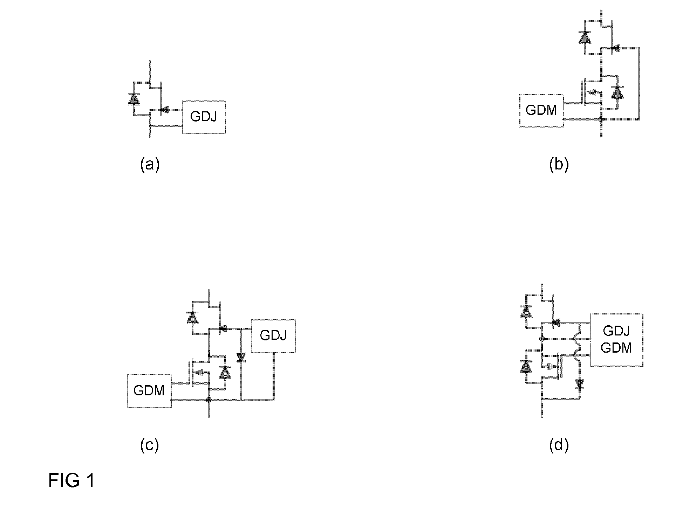

Figure 1 shows some known principles of driving normally-on JFET switches. In Figure 1 (a) a basic JFET driver is shown [1], [2]. The driver is connected to the source and gate electrodes of the normally-on JFET. In operation, the gate driver is able to draw the gate electrode of the JFET to negative potential with respect to the source electrode for turning the component off and for keeping the component in a non-conductive state. For turning the component conductive, the gate electrode of the JFET is controlled to the same potential as the source.

In Figure 1 (b) a cascode structure using a MOSFET driver is presented [3], [4]. In Figure 1(b) shows the conventional cascode structure, where a low-voltage MOSFET is connected in series with the JFET and the gate of the JFET is connected to the source of the MOSFET. Since the JFET is driven by the drain-source voltage of the MOSFET, only the gate driver for the MOSFET is required. In the driver of Figure 1 (b) the dv/dt control of the JFET is difficult, since it is indirectly controlled by the MOSFET. Further, the drain-source voltage of the MOSFET may reach the avalanche of the drain-source of the MOSFET or the avalanche of the gate-source of the JFET, which may require an additional protection circuit. Also turn-on losses may increase owing to the additional MOSFET.

Figure 1 (c) shows a direct-driven cascode structure with individual JFET and MOSFET drivers [5],[6] and Figure 1 (d) shows a direct-driven cascode structure with integrated driver and P-MOSFET [7].

To compensate for the drawbacks of the conventional cascode structure, the direct-driven cascode structure shown in Figures 1(c) and 1(d) has been recently considered. The MOSFET is always in on-state during normal operation so that it does not affect the switching action and the JFET is directly controlled by its own gate driver. The MOSFET is switched off only for protection purposes and at startup. For contingency, one additional diode is connected between the gate of the JFET and the source of the MOSFET, which allows a conventional cascode operation when the control signal is lost, i.e. allows operating the JFET with the operation of the MOSFET.

Therefore, the above mentioned drawbacks of the conventional cascode structure can be solved. However, this configuration requires individual gate drivers for both the JFET and the MOSFET, which increases the circuit complexity and the system cost.

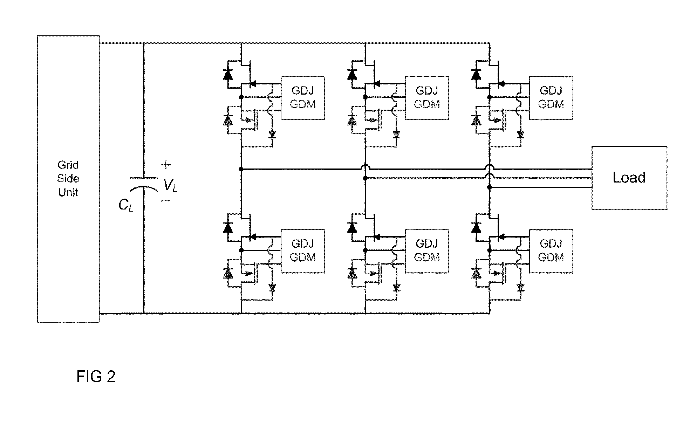

As an example, Figure 2 shows a 3-phase 2-level inverter using the N-on JFETs with direct-driven cascode structure. Although this configuration is promising in terms of protection and startup, the total numbers of components is very large due to the additional MOSFETs and their gate drivers.

### BRIEF DESCRIPTION OF THE INVENTION

An object of the present invention is to provide a protection circuit for implementing the method so as to solve the above problems. The objects of the invention are achieved by a circuit which is characterized by what is stated in the independent claim. The preferred embodiments of the invention are disclosed in the dependent claims.

The invention is based on the idea of using a single MOSFET for a plurality of N-on JFETs for providing short-circuit protection. With a single MOSFET component the multiple JFETs can be controlled to blocking state. When the MOSFET component is turned conductive, the JFETs can operate in a normal manner, switching the current and voltage.

An advantage of the circuit of the invention is that the number of components is greatly reduced and the circuit structure is therefore simplified. As the number of controlled components is reduced, the need for providing control signals is also reduced together with the circuitry required for the control signals.

### BRIEF DESCRIPTION OF THE DRAWINGS

In the following the invention will be described in greater detail by means of preferred embodiments with reference to the attached drawings, in which
Figures 1 a, b, c and d show conventional driving circuits for normally-on component;
Figure 2 shows an inverter circuit with conventional cascode drivers; and
Figures 3, 4 and 5 show different circuit topologies with the circuit of the present invention.

### DETAILED DESCRIPTION OF THE INVENTION

With regard to the N-on JFET in bridge-type voltage source converters, as shown for example in Figure 2, a short circuit in a phase leg is the most critical problem caused by the normally-on characteristic of the JFETs in case the gate control is lost. A straightforward solution is to utilize the cascode structure for all switches, as in Figure 2, which can be considered to be a diode rectifier when all switches are in off-state. However, according to the present invention, not every JFET needs to have an individual MOSFET to prevent a short circuit.

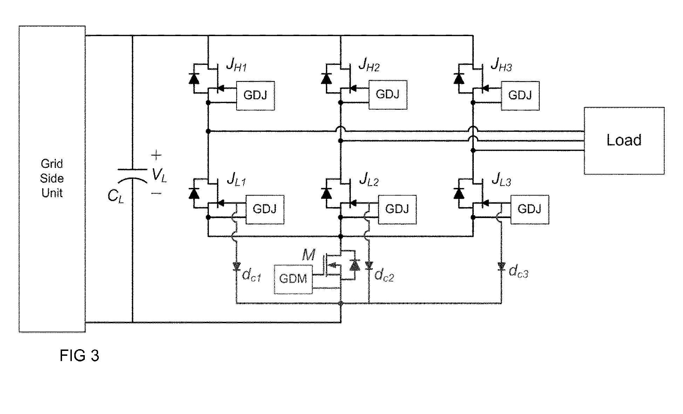

The circuit of the present invention comprises a diode for each of the low-side normally-on switch. The diodes are connected such that the anodes of the diodes are connected to the gate electrodes of the respective low-side normally-on switches and the cathodes of the diodes are connected to a common point. In the example of Figure 3 the common point to which the cathodes of the diodes are connected is the negative bus of the DC intermediate link.

The circuit of the present invention comprises further a controllable semiconductor switch M connected between the potential of source electrodes of the low-side normally-on switches J_{L1}, J_{L2}, J_{L3} and the common point to which the cathodes of the diodes d_{c1}, d_{c2}, d_{c3} are connected.

Figure 3 shows the circuit of the present invention applied to a 3-phase 2-level inverter. The operation of the inverter itself is not described here in detail. Typically, an inverter is used for producing voltage to the load from the intermediate circuit voltage or DC link voltage V_{L}. The inverter switches either positive or negative voltage to the load using series connected high-side and low-side switches. The DC voltage is produced to the DC link using a grid side unit, such as a rectifier.

The protective operation of the cascode structure of the invention is the same as that of the direct-driven cascode structure shown in Figure 2, except that it utilizes only one additional MOSFET M, one gate driver GDM, and three diodes d_{c1}, d_{c2}, d_{c3}.

When the MOSFET M of Figure 3 is in off-state, all three low-side JFETs J_{L1}, J_{L2}, J_{L3} are also turned off by the cascode structure formed by diodes d_{c1}, d_{c2}, d_{c3} and the MOSFET M. Therefore, during startup or in case of a fault, the three low-side JFETs behave as in the case of the conventional cascode structure. Since the low-side JFETs can sustain the entire link voltage V_{L}, the high-side JFETs J_{H1}, J_{H2}, J_{H3} do not need to be in off-state. Consequently, only one MOSFET for the low-side JFETs is enough to prevent a short circuit in a phase leg.

After the auxiliary power supply has started its operation and the JFET drivers GDJ are functioning, the MOSFET M is turned on with the MOSFET driver GDM and the normal operation of the inverter may begin. Because of the reverse blocking of diodes d_{c1}, d_{c2}, d_{c3}, the gate-source voltages of the JFETs are not affected by the on-state of the MOSFET. Even though the MOSFET handles the entire input current of the inverter, the conduction loss of a low-voltage MOSFET ( < 50 V) is negligible.

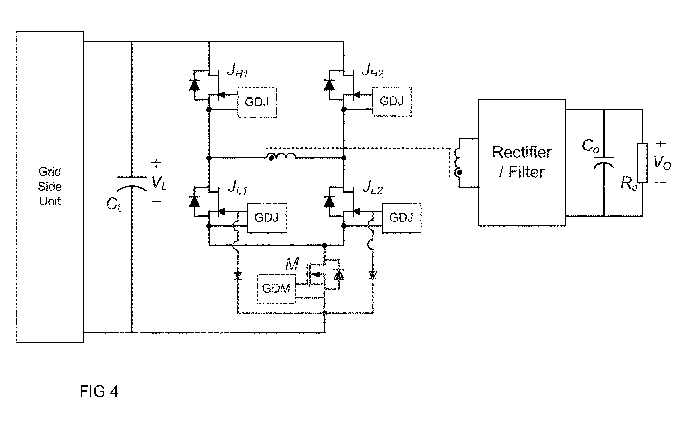

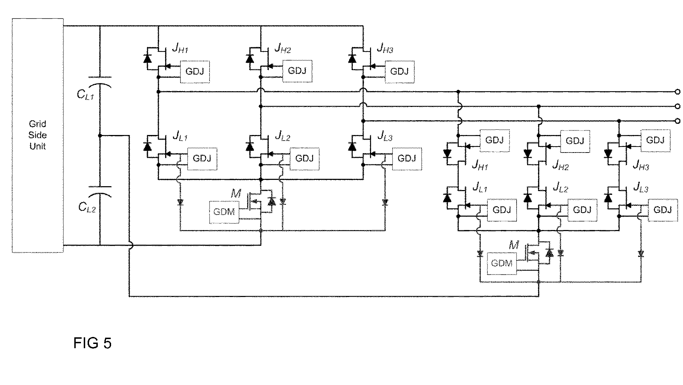

As can be seen in Figures 4 and 5, the cascode circuit structure may also be applied to other topologies, such as a dc-dc full-bridge converter (Figure 4) and a hybrid 3-level (T-shape) inverter (Figure 5). The requirement for using the circuit of the invention is that the source terminals of the JFETs are connected to one common point. The topologies of Figures 4 and 5 are not described in detail since the topologies themselves are known as such.

It should be noted that, for example in the circuit of Figure 5, the number of components is greatly reduced due to use of the invention. Further, Figure 5 shows how the circuit of the invention is employed in two places of the same converter circuit. The cascode structure is used in the inverter structure and also in the circuit connecting the intermediate voltage between the capacitors CL1 and CL2 to the output of the converter. In this connection the common point to which the cathodes of the diodes are connected is the DC link midpoint between the capacitors CL1 and CL2.

The main benefit of the invention is a simple implementation of the cascode structure in bridge type voltage source converters. With regard to the conventional 3-phase 2-level converter in particular, it requires only one additional low-voltage MOSFET and one gate driver, which makes it significantly simpler compared to the direct-driven cascode structure shown in Figure 2. It should be noted that the proposed structure is not limited to this topology alone, but may also be applied to other types of converters.

It will be obvious to a person skilled in the art that, as the technology advances, the inventive concept can be implemented in various ways. The invention and its embodiments are not limited to the examples described above but may vary within the scope of the claims.

### References

[1] S. Round et al, "A SiC JFET driver for a 5 kW, 150 kHz three-phase sinusoidal-input, sinusoidal-output PWM converter,"
[2] D. Bergogne et al, "Normally-on SiC JFETs in power converters : gate driver and safe operation," CIPS 2010.
[3] AN-SS7 - SSJHB12R085-1 Half-bridge demo board user's guide, Semisouth.
[4] US20120105131(A1), 3-May-2012, Switching device with a cascode circuit.
[5] R. Siemieniec, G. Nöbauer, and D. Domes, "Stability and performance analysis of a SiC-based cascode switch and an alternative solution,"
[6] DE102006029928(B3), 06-Sep-2007, Electronic switching device for switching high electric current, has isolating unit connected between control connection of switching unit and load supply of another switching unit, where isolation unit decouples switching units.
[7] D. Domes, C. Messelke, and P. Kanschat, "1st industrialized 1200 V SiC JFET module for high energy efficiency applications," PCIM Europe 2011, pp. 567-572.

## Claims

1. A circuit with short circuit protection comprising
two or more series connections of normally-on switches, each series connection comprising a high-side and a low-side normally-on switch, wherein the source electrodes of the low-side normally-on switches (J_{L1}, J_{L2}, J_{L3}) being connected to a same potential, and
gate drivers (GDJ) for controlling the normally-on switches, **characterized in that** the circuit further comprises
a diode (d_{c1}, d_{c2}, d_{c3}) for each of the low-side normally-on switch, the anodes of the diodes being connected to the gate electrodes of the respective low-side normally-on switches and the cathodes of the diodes are connected to a common point, and
a controllable semiconductor switch (M) connected between the potential of source electrodes of the low-side normally-on switches (J_{L1}, J_{L2}, J_{L3}) and the common point to which the cathodes of the diodes (d_{c1}, d_{c2}, d_{c3}) are connected.

2. A circuit according to claim 1, **characterized in that** the circuit is a converter circuit in which the series connections of normally-on switches form phase legs.

3. A circuit according to claim 1 or 2, **characterized in that** the controllable semiconductor switch (M) is adapted to control the low-side normally-on switches to a blocking state when the controllable semiconductor switch is controlled to the blocking state.

4. A circuit according to claim 1, 2 or 3, **characterized in that** the circuit further comprises an intermediate voltage circuit and the two or more series connections of normally-on switches are connected between the intermediate voltage circuit, whereby the common point to which the cathodes of the diodes are connected is the negative bus of the intermediate voltage circuit.

5. A circuit according to any one of the previous claims 1 to 4, **characterized in that** the common point to which the cathodes of the diodes are connected in a midpoint of a DC link, the first ends of the series connection of normally-on switches being connected at the output of a converter for providing a three-level T-shape converter.

6. A circuit according to any one of the previous claims 1 to 5, **characterized in that** the circuit is an inverter.

7. A circuit according to any of the previous claims 1 to 5, **characterized in that** the circuit is a DC-to-DC converter.

8. A circuit according to any of the previous claims 1 to 5, **characterized in that** the circuit is a controlled rectifier.

9. A circuit according to any of the previous claims 1 to 8, **characterized in that** normally-on switches are normally-on JFETs.
